(19) Europäisches Patentamt

European Patent Office

Office européen des brevets

(11) EP 2 550 539 B1

(12) **FASCICULE DE BREVET EUROPEEN**

(45) Date de publication et mention de la délivrance du brevet:
**14.08.2019 Bulletin 2019/33**

(21) Numéro de dépôt: **11715977.2**

(22) Date de dépôt: **23.03.2011**

(51) Int Cl.:
*G01R 31/40* (2014.01)          *H02J 7/34* (2006.01)
*H02M 3/137* (2006.01)          *H02M 7/217* (2006.01)

(86) Numéro de dépôt international:
**PCT/FR2011/050614**

(87) Numéro de publication internationale:
**WO 2011/117537 (29.09.2011 Gazette 2011/39)**

(54) **PROCÉDÉ ET DISPOSITIF DE DÉTERMINATION DE LA VALEUR D'UNE GRANDEUR CARACTÉRISTIQUE D'UN SYSTÈME D'ALIMENTATION D'UNE CHARGE**

VERFAHREN UND VORRICHTUNG ZUR VORDEFINITION EINES WERTES FÜR CHARAKTERISTISCHE GRÖSSEN AUS LASTVERSORGUNGSSYSTEMEN

METHOD AND DEVICE FOR PREDETERMINING VALUE FOR CHARACTERISTIC QUANTITY FROM LOAD-SUPPLYING SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.03.2010 FR 1052076**

(43) Date de publication de la demande:
**30.01.2013 Bulletin 2013/05**

(73) Titulaire: **GE Energy Power Conversion Technology Limited**
**Rugby**
**Warwickshire CV21 1BU (GB)**

(72) Inventeurs:
• **GOLLENTZ, Bernard**
  **F-68360 Soultz (FR)**
• **PERON, Régis**
  **F-90000 Belfort (FR)**
• **GIROD, Daniel**
  **F-90300 Cravanche (FR)**

(74) Mandataire: **Serjeants LLP**
**Dock**
**75 Exploration Drive**
**Leicester, LE4 5NU (GB)**

(56) Documents cités:
**EP-A1- 1 868 279     US-A- 5 638 263**

• **BORDRY F ET AL: "CERN-PS Main Power Converter Renovation: How to Provide and Control the Large Flow of Energy for A Rapid Cycling Machine", PARTICLE ACCELERATOR CONFERENCE, 2005. PAC 2005. PROCEEDINGS OF THE KNOXVILLE, TN, USA 16-20 MAY 2005, PISCATAWAY, NJ, USA,IEEE LNKD-DOI:10.1109/PAC.2005.1591556, 16 mai 2005 (2005-05-16), pages 3612-3614, XP010892123, ISBN: 978-0-7803-8859-8**

**Description**

La présente invention concerne un procédé de détermination de la valeur d'une grandeur caractéristique d'un système d'alimentation d'une charge comprenant M convertisseur(s) d'un courant continu en un autre courant continu connecté(s) en série aux bornes de la charge d'une part et en sortie d'une alimentation en courant continu d'autre part, M étant supérieur ou égal à 1, et au moins un condensateur de stockage monté en parallèle du ou des convertisseurs du côté opposé à la charge.

La présente invention concerne également un dispositif de détermination de la valeur d'une telle grandeur caractéristique.

La présente invention concerne également un système d'alimentation d'une charge comportant un tel dispositif de détermination.

En particulier, l'invention s'applique à un système d'alimentation de puissance élevée, typiquement de l'ordre de 50 MW. Un tel système d'alimentation est typiquement destiné à alimenter une charge nécessitant d'être alimentée par une alimentation puisée, telle qu'une bobine de guidage d'un synchrotron à protons par exemple.

Un procédé de détermination et un dispositif de détermination des types précités sont décrits dans le document EP 1 868 279 A1. Les tensions aux bornes de chaque convertisseur du côté du condensateur de stockage sont mesurées par un instrument de mesure. La résolution des valeurs de ces tensions dépend donc directement de la résolution de l'instrument de mesure, la résolution étant la plus petite variation de mesure que l'instrument de mesure est capable de déceler. Autrement dit, la résolution est le nombre de valeurs différentes que l'instrument de mesure est capable de délivrer pour un intervalle de mesure donné. La détermination de valeurs avec une forte résolution de ces tensions nécessite alors que l'instrument de mesure présente une forte résolution.

Le préambule des revendications indépendantes peut être dérivée de BORDRY F ET AL : « CERN-PS Main Power Converter Rénovation : How to Provide and Control the Large Flow of Energy for a Rapid Cyclic Machine ? » ; Proceedings of the Particle Accelerator Conférence, 2005 ; Knoxville, TN, USA, 16-20 mai 2005 ; pages 3612-3614, IEEE - ISBN 0-7803-8859-3.

Le but de l'invention est de proposer un procédé de détermination d'une valeur avec une forte résolution d'une grandeur caractéristique ne nécessitant pas de mesurer directement la valeur de cette grandeur caractéristique avec un instrument de mesure de forte résolution.

A cet effet, l'invention a pour objet un procédé de détermination du type précité, caractérisé en ce qu'il comprend les étapes suivantes :

- la mesure d'une pluralité de valeurs avec une première forte résolution d'une première grandeur caractéristique,
- la mesure d'une valeur avec une faible résolution d'une deuxième grandeur caractéristique, et
- la détermination d'une valeur avec une deuxième forte résolution de la deuxième grandeur caractéristique à partir de la pluralité de valeurs mesurées avec la première forte résolution de la première grandeur caractéristique et de la valeur avec la faible résolution de la deuxième grandeur caractéristique, les première et deuxième fortes résolutions étant au moins 10 fois supérieures à la faible résolution.

Suivant d'autres modes de réalisation, le procédé de détermination comprend une ou plusieurs des caractéristiques suivantes, prises isolément ou suivant toutes les combinaisons techniquement possibles :

- la détermination de la valeur avec la deuxième forte résolution de la deuxième grandeur caractéristique comporte une pluralité d'itérations, une valeur suivante de la deuxième grandeur caractéristique étant calculée, à chaque itération, à partir d'une valeur précédente de la deuxième grandeur caractéristique et d'un terme correctif dépendant de la valeur mesurée, à chaque itération, avec la première forte résolution de la première grandeur caractéristique, la valeur initiale de la deuxième grandeur caractéristique étant égale à la valeur avec faible résolution de la deuxième grandeur caractéristique,
- la première grandeur caractéristique est l'intensité du courant délivré à la charge et la deuxième grandeur caractéristique est la tension aux bornes du convertisseur du côté du condensateur de stockage,
- chacun des M convertisseur(s) est connecté en sortie de l'alimentation en courant continu et la valeur suivante U1dc(n) de la tension aux bornes du convertisseur du côté du condensateur de stockage est déterminée à partir de la valeur précédente U1dc(n-1) selon l'équation suivante :

$$U1dc(n) = U1dc(n\text{-}1) + \frac{h(Ic)}{U1dc(n-1)},$$

où h(Ic) représente un terme fonction de l'intensité du courant délivré à la charge.

- M est strictement supérieur à 1, et la pluralité de M convertisseurs est constituée de N1 premier(s) convertisseur(s) connecté(s) en sortie de l'alimentation en courant continu, N1 étant supérieur ou égal à 1, et de N2 second(s) convertisseur(s) qui ne sont pas connecté(s) en sortie de ladite alimentation, N2 étant supérieur ou égal à 1, la somme de N1 et N2 étant égale à M,
- la deuxième grandeur caractéristique est la tension aux bornes de chaque premier convertisseur du côté du condensateur de stockage associé et la valeur suivante U1dc(n) de ladite tension aux bornes du premier convertisseur est calculée à partir de la valeur précédente U1dc(n-1) de la tension aux bornes du premier convertisseur selon l'équation suivante :

$$U1dc(n) = U1dc(n\text{-}1) + \frac{f(Ic)}{\text{U1dc}(n-1)}$$

où f(Ic) représente un terme fonction de l'intensité du courant délivré à la charge.
- la deuxième grandeur caractéristique est la tension aux bornes de chaque second convertisseur du côté du condensateur de stockage, et dans lequel la valeur suivante U2dc(n) de ladite tension aux bornes du second convertisseur est calculée à partir de la valeur précédente U2dc(n-1) de ladite tension aux bornes du second convertisseur selon l'équation suivante :

$$U2dc(n) = U2dc(n\text{-}1) + \frac{g(Ic)}{\text{U2dc}(n-1)}$$

où g(Ic) représente un terme fonction de l'intensité du courant délivré à la charge (12).
- les première et deuxième fortes résolutions comportent chacune entre 17 et 32 bits.
- la faible résolution comporte entre 5 et 15 bits, de préférence 11 bits.
- la période entre deux itérations est égale à 1 ms.

L'invention a également pour objet un dispositif de détermination d'une grandeur caractéristique d'un système d'alimentation d'une charge comprenant M convertisseur(s) d'un courant continu en un autre courant continu connecté(s) en série aux bornes de la charge, M étant supérieur ou égal à 1, et au moins un condensateur de stockage monté en parallèle du ou des convertisseurs du côté opposé à la charge, caractérisé en ce qu'il comprend :

- des moyens de mesure d'une pluralité de valeurs avec une première forte résolution d'une première grandeur caractéristique,
- des moyens de mesure d'une valeur avec une faible résolution d'une deuxième grandeur caractéristique, et
- des moyens de détermination d'une valeur avec une deuxième forte résolution de la deuxième grandeur caractéristique à partir de la pluralité de valeurs mesurées avec la première forte résolution de la première grandeur caractéristique et de la valeur avec la faible résolution de la deuxième grandeur caractéristique, les première et deuxième fortes résolutions étant au moins 10 fois supérieures à la faible résolution.

L'invention a également pour objet un système d'alimentation d'une charge, du type comprenant :

- une alimentation en courant continu reliée à un réseau électrique,
- M convertisseur(s) d'un courant continu en un autre courant continu connecté(s) en série aux bornes de la charge, M étant supérieur ou égal à 1,
- au moins un condensateur de stockage monté en parallèle du ou des convertisseurs du côté opposé à la charge, et
- un dispositif de détermination de la valeur d'une grandeur caractéristique du système d'alimentation,

caractérisé en ce que le dispositif de détermination est tel que défini ci-dessus.
Suivant d'autres modes de réalisation, le système d'alimentation comprend une ou plusieurs des caractéristiques suivantes, prises isolément ou suivant toutes les combinaisons techniquement possibles dans lesquelles :

- l'alimentation en courant continu comprend au moins un transformateur de tension alternative est relié au réseau électrique et au moins un redresseur de tension est connecté en sortie du transformateur de tension.
- chacun des M convertisseur(s) est connecté en sortie de l'alimentation en courant continu,
- M est strictement supérieur à 1 et la pluralité de M convertisseurs est constituée de N1 premier(s) convertisseur(s) connecté(s) en sortie de l'alimentation en courant continu, N1 étant supérieur ou égal à 1, et de N2 second(s) convertisseur(s) qui ne sont pas connecté(s) en sortie de ladite alimentation, N2 étant supérieur ou égal à 1, la somme de N1 et N2 étant égale à M.

Ces caractéristiques et avantages de l'invention apparaîtront à la lecture de la description qui va suivre, donnée uniquement à titre d'exemple, et faite en référence aux dessins annexés, sur lesquels :

- la figure 1 est une représentation schématique d'un système d'alimentation selon l'invention comportant six convertisseurs d'un courant continu en un autre courant continu,
- la figure 2 est un organigramme du procédé de détermination selon l'invention,
- la figure 3 est un ensemble de courbes représentant, en fonction du temps, les tensions aux bornes d'un premier convertisseur, et respectivement d'un second convertisseur, et
- les figures 4, 5, 6 et 7 sont respectivement des agrandissements des zones encadrées IV, V, VI et VII de la figure 3.

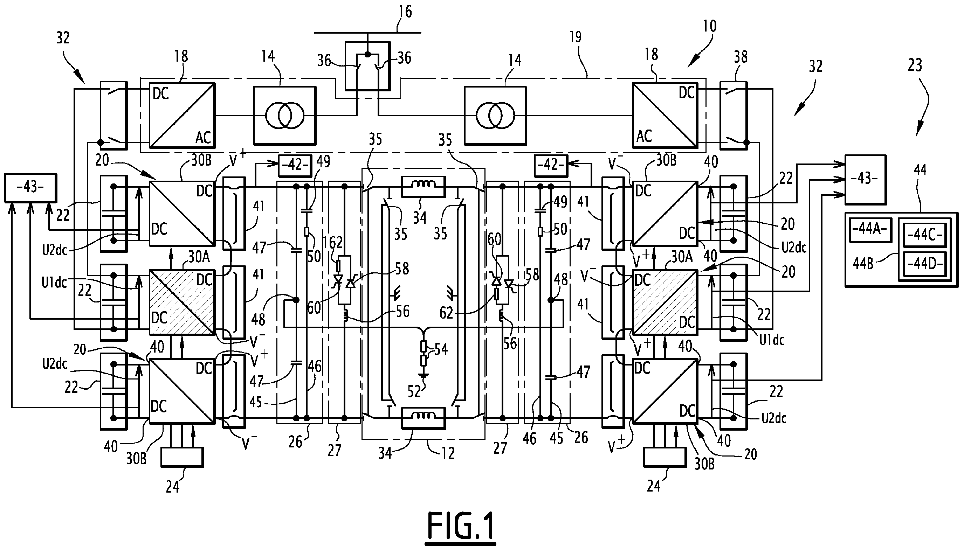

Sur la figure 1, un système 10 d'alimentation d'une charge 12 comprend deux transformateurs de tension alternative 14 reliés à un réseau électrique 16, et deux redresseurs de tension 18, chacun étant connecté en sortie d'un transformateur de tension 14. Les transformateurs de tension 14 et les redresseurs de tension 18 forment une alimentation en courant continu 19 reliée au réseau électrique 16. L'alimentation en courant continu 19 est propre à délivrer une puissance électrique $P_{alim}$ de valeur maximale égale à 12,5 MW.

Le système d'alimentation 10 comporte également M convertisseurs 20 d'un courant continu en un autre courant continu et M condensateurs de stockage 22, chacun étant monté en parallèle d'un convertisseur 20 respectif. Les M convertisseurs 20 sont connectés en série aux bornes de la charge 12. M est supérieur ou égal à 1.

Le système d'alimentation 10 comporte également un dispositif 23 de détermination de la valeur de la tension aux bornes des convertisseurs 20 respectifs du côté du condensateur de stockage 22, des moyens 24 de commande des convertisseurs 20, deux filtres 26 connectés entre la charge 12 et les convertisseurs 20, et deux dispositifs 27 de décharge de la charge 12 en cas de défaut de celle-ci.

Dans l'exemple de réalisation de la figure 1, les M convertisseurs sont constitués de N1 premiers convertisseurs 30A dits convertisseurs de charge connectés en sortie d'un redresseur 18 respectif et de N2 deuxièmes convertisseurs 30B dits convertisseurs flottants. Les N2 convertisseurs flottants 30B ne sont pas connectés directement en sortie des redresseurs. N1 et N2 sont supérieurs ou égaux à 1. La somme de N1 et de N2 est égale à M.

Dans l'exemple de réalisation de la figure 1, M est un nombre pair supérieur ou égal à 4, par exemple égal à 6. N1 est égal à 2, et N2 est égal à 4.

En variante non représentée, les M convertisseurs sont connectés en série aux bornes de la charge d'une part, et en sortie de l'alimentation en courant continu d'autre part. Autrement dit, les M convertisseurs sont des convertisseurs de charge connectés en sortie d'un redresseur respectif, et N1 est égal à M. Chaque convertisseur de charge présente une tension U1dc à ses bornes du côté du condensateur de stockage associé.

La charge 12 comporte une bobine de guidage d'un synchrotron à protons séparée en deux demi-bobines 34, et des relais 35 d'isolement des demi-bobines 34. La charge 12 présente une inductance Lc, par exemple égale à 9 mH, une résistance interne Rc, par exemple égale à 3,2 mΩ, une capacité Cc, par exemple égale à 22 nF, et une résistance d'amortissement pc, par exemple égale à 136 Ω.

Le courant délivré à la charge 12 par les convertisseurs 20 présente une intensité Ic, et la tension aux bornes de la charge 12 comporte une composante résistive $V_R$ et une composante inductive $V_L$.

Chaque transformateur de tension alternatif 14 est connecté au réseau électrique 16 par l'intermédiaire d'un premier relais 36.

Le réseau électrique 16 est un réseau alternatif polyphasé propre à délivrer au système d'alimentation 10 un courant comportant une pluralité de phases. Le réseau électrique 16 est, par exemple, un réseau triphasé.

Chaque redresseur 18 est un convertisseur d'un courant alternatif d'entrée en un courant continu de sortie, et est connecté en sortie au premier convertisseur 30A correspondant par l'intermédiaire de deuxièmes relais 38 propres à isoler le premier convertisseur 30A de son redresseur 18 respectif en cas de besoin.

Tous les convertisseurs 20 sont identiques dans leur structure, seule leur loi de commande étant propre à chacun.

Chaque convertisseur 20 d'un courant continu en un autre courant continu, également appelé hacheur, comporte deux premières bornes 40 reliées au condensateur de stockage 22 respectif et deux deuxièmes bornes V+, V-. Chaque borne V+ d'un hacheur 20 est connectée à la borne V- d'un hacheur 20 adjacent, les hacheurs 20 étant connectés en série aux bornes de la charge 12. Les deux deuxièmes bornes V+, V- disposées aux extrémités des hacheurs 20 en série, et non connectées à une deuxième borne correspondante d'un autre hacheur, sont connectées aux bornes de la charge 12.

Chaque convertisseur de charge 30A présente une tension U1dc entre ses bornes 40 du côté du condensateur de stockage associé, et chaque convertisseur flottant 30B présente une tension U2dc entre ses bornes 40 du côté du condensateur de stockage associé.

Chaque hacheur 20 est propre à faire varier la tension du courant circulant à travers les deuxièmes bornes V+, V- par rapport au courant circulant à travers les premières bornes 40. Chaque hacheur 20 est réversible, le courant étant propre à circuler depuis le condensateur 22 correspondant vers la charge 12 au cours d'un intervalle de temps et à circuler dans le sens inverse depuis la charge 12 vers le condensateur 22 au cours d'un autre intervalle de temps.

Chaque hacheur 20 comporte deux modules, non représentés, formant un pont en H. Chaque module est connecté entre les deux premières bornes 40 d'une part, et une deuxième borne V+, V- respective d'autre part. Chaque module comprend une ou plusieurs branche(s) de commutation, de préférence identiques. Chaque branche de commutation forme, par exemple, un onduleur de tension à trois niveaux. En variante, chaque branche de commutation forme un onduleur de tension à deux niveaux.

Tous les condensateurs de stockage 22 sont identiques dans leur structure, et présentent chacun une capacité C.

Le système d'alimentation 10 comporte également M shunts commandables 41, chacun étant disposé en parallèle des deuxièmes bornes V+, V- d'un hacheur respectif. Chaque shunt 41 est propre, lorsqu'il est commandé, à mettre en court-circuit les deux deuxièmes bornes V+, V- du hacheur correspondant.

Le dispositif de détermination 23 comprend des moyens 42 de mesure d'une pluralité de valeurs successives avec une première forte résolution d'une intensité Ic du courant délivré à la charge 12, des moyens 43 de mesure d'une valeur avec une faible résolution de la tension U1dc, U2dc aux bornes du convertisseur 20 du côté du condensateur de stockage. Le dispositif de détermination 23 comprend également des moyens 44 de détermination d'une valeur avec une deuxième forte résolution de la tension U1dc, U2dc à partir de la pluralité de valeurs mesurées avec la première forte résolution de l'intensité Ic du courant délivré à la charge et de la valeur avec la faible résolution de la tension U1dc, U2dc aux bornes du convertisseur du côté du condensateur de stockage.

Les première et deuxième fortes résolutions comporte, par exemple, entre 17 et 32 bits. La première forte résolution et la deuxième forte résolution comportent de préférence 32 bits. Autrement dit, les moyens de détermination 44 sont, par exemple, propres à déterminer une valeur de la tension U1dc, U2dc parmi $2^{32}$ valeurs différentes, soit 4294967296 valeurs différentes, pour un intervalle de mesure donné. Pour la mesure d'une tension entre 0 et 10 kV, la plus petite variation de mesure propre à être déterminée par les moyens de détermination 44 est alors égale à 10 kV / $2^{32}$, soit environ 2,3 μV.

La faible résolution comporte, par exemple, entre 5 et 15 bits, de préférence 11 bits. Autrement dit, les moyens de mesure 43 sont, par exemple, propres à mesurer une valeur de la tension U1dc, U2dc parmi $2^{11}$ valeurs différentes, soit 2048 valeurs différentes, pour un intervalle de mesure donné.

Les première et deuxième fortes résolutions sont au moins 10 fois supérieures à la faible résolution. La deuxième forte résolution comportant $2^{32}$ valeurs différentes pour un intervalle de mesure donné est, par exemple, $2^{21}$ fois, soit 2097152 fois, supérieure à la faible résolution comportant $2^{11}$ valeurs différentes pour l'intervalle de mesure. La première forte résolution est, par exemple et de manière analogue, $2^{21}$ fois, soit 2097152 fois, supérieure à la faible résolution.

Les moyens de mesure 42 comportent, par exemple, un ampèremètre propre à mesurer une intensité du courant avec la première forte résolution.

Les moyens de mesure 43 comportent un capteur de tension à faible résolution.

Les moyens de détermination 44 sont reliés aux moyens de mesure 42, 43. Les moyens de détermination 44 comportent une unité de traitement d'information formée, par exemple, d'un processeur de données 44A associé à une mémoire 44B. La mémoire 44B est apte à stocker un logiciel 44C d'acquisition des valeurs mesurées par les moyens de mesure 42, 43, et un logiciel 44D de détermination d'une valeur avec la deuxième forte résolution de la tension U1dc, U2dc à partir de la pluralité de valeurs mesurées avec la première forte résolution par les moyens de mesure 42 et de la valeur avec la faible résolution mesurée par les moyens de mesure 43.

En variante, les moyens de détermination 44 sont réalisés sous forme de composants logiques programmables, ou encore sous forme de circuits intégrés dédiés.

Chaque filtre 26 est agencé entre la charge 12 et un ensemble de convertisseurs 28 respectifs, et comporte une première branche 45 et une deuxième branche 46, les deux branches 45, 46 étant en parallèle l'une de l'autre. La première branche 45 comprend deux condensateurs 47 connectés en série entre les bornes de la charge 12, les deux condensateurs 47 étant connectés entre eux en un point milieu 48. La deuxième branche 46 comprend un condensateur 49 et une résistance 50 connectés en série entre les bornes de la charge 12. Les points milieux 48 de chacune des premières branches 45 des filtres sont connectés entre eux et reliés à une masse électrique 52 par l'intermédiaire de résistances 54.

Le dispositif de décharge 27 est connecté en parallèle de la charge 12 entre ses bornes respectives. Le dispositif de décharge 27 comporte une bobine 56 connectée en série à un ensemble de composants comportant un premier thyristor 58 connecté en parallèle d'un deuxième thyristor 60 et d'une résistance de décharge 62 connectés en série. Les premier 58 et second 60 thyristors sont connectés tête-bêche.

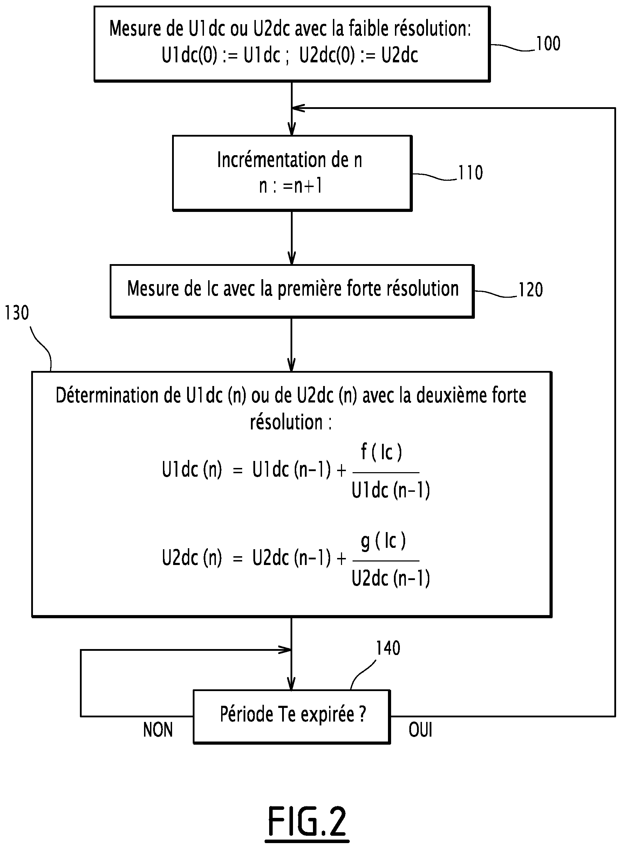

La figure 2 illustre un procédé de détermination de la valeur de la tension U1dc, U2dc aux bornes du convertisseur

20 du côté du condensateur de stockage 22 associé.

A l'étape 100, les moyens de mesure 43 mesurent une unique valeur avec la faible résolution de la tension U1dc, U2dc aux bornes du convertisseur 20 du côté du condensateur de stockage associé.

La détermination de la valeur avec la deuxième forte résolution de la tension U1dc, U2dc, comporte, par exemple, une pluralité d'itérations. Une valeur suivante U1dc(n), U2dc(n) de la tension aux bornes du convertisseur est calculée, à chaque itération, à partir d'une valeur précédente U1dc(n-1), U2dc(n-1) de la tension aux bornes du convertisseur et d'un terme correctif.

La valeur initiale U1dc(0), U2dc(0) de la tension aux bornes du convertisseur est égale à la valeur mesurée, lors de l'étape 100, avec la faible résolution de la tension U1dc, U2dc aux bornes du convertisseur.

n représente un indice d'itération. La valeur de l'indice n est incrémentée d'une unité à l'étape 110.

Le terme correctif dépend de la valeur mesurée avec la première forte résolution de l'intensité Ic du courant délivré à la charge. Cette valeur de l'intensité Ic est mesurée à chaque itération lors de l'étape 120 par les moyens de mesure 42. Les moyens de mesure 42 mesurent ainsi lors de la mise en oeuvre du procédé de détermination une pluralité de valeurs successives avec la première forte résolution de l'intensité Ic du courant délivré à la charge 12.

Les moyens de détermination 44 calculent alors à l'étape 130 la valeur suivante U1dc(n), U2dc(n) de la tension aux bornes du convertisseur à partir de la valeur mesurée avec la première forte résolution de l'intensité Ic du courant délivré à la charge (étape 120) et de la valeur avec la faible résolution de la tension U1dc, U2dc aux bornes du convertisseur (étape 100).

Lorsque la période d'échantillonnage Te est expirée à l'issue de l'étape 140, le procédé de détermination est itéré en retournant à l'étape 110.

Le procédé de détermination comporte autant d'itérations que nécessaire pour que la valeur de la deuxième forte résolution soit au moins 10 fois supérieure à celle de la faible résolution. Le nombre minimal N d'itérations est, par exemple, supérieur à 50, de préférence supérieur à 80, de préférence encore égal à 100.

Les moyens de détermination 44 déterminent ainsi, à l'étape 130 de la N$^{\text{ième}}$ itération, une valeur avec la deuxième forte résolution de la tension U1dc, U2dc aux bornes du convertisseur 20 à partir de la pluralité de valeurs successives mesurées avec la première forte résolution de l'intensité Ic du courant délivré à la charge et de la valeur avec la faible résolution de la tension U1dc, U2dc aux bornes du convertisseur.

La composante résistive $V_R$ de la tension aux bornes de la charge est, par exemple, fournie uniquement par les convertisseurs de charge 30A. La composante inductive $V_L$ de la tension aux bornes de la charge est quant à elle délivrée à la fois par les convertisseurs de charge 30A et par les convertisseurs flottants 30B.

La répartition de la composante inductive $V_L$ entre les convertisseurs 30A et les convertisseurs flottants 30B est définie par des coefficients de répartition entre les convertisseurs de la composante inductive $V_L$, à savoir un premier coefficient de répartition K1 associé aux convertisseurs de charge 30A et un second coefficient de répartition K2 associé aux convertisseurs flottants 30B. Les coefficients de répartition K1, K2 ont des valeurs respectives prédéterminées. La composante inductive $V_L$ est, par exemple, délivrée en majeure partie par les convertisseurs flottants 30B, et la valeur prédéterminée de K2 est alors supérieure à celle de K1.

Les premier et second coefficients de répartition K1, K2, vérifient l'équation suivante :

$$N1 \times K1 + N2 \times K2 = 1 \qquad (1)$$

Lorsque la tension déterminée est la tension U1dc aux bornes de chacun des N1 convertisseurs de charge 30A, la valeur suivante U1dc(n) de ladite tension est calculée à partir de la valeur précédente U1dc (n-1) de ladite tension selon l'équation suivante :

$$U1dc(n) = U1dc(n\text{-}1) + \frac{f(Ic)}{U1dc(n-1)} \qquad (2)$$

où f(Ic) représente un terme fonction de l'intensité Ic du courant délivré à la charge.

La fonction f est, par exemple, déterminée à l'aide de l'équation suivante :

$$f(Ic) = \frac{1}{C} \times \left( \frac{1}{N1}\left(P_{\text{alim}} - V_R.Ic\right) - K1.V_L.Ic \right) \times T_e, \qquad (3)$$

où $T_e$ représente la période entre deux itérations.

Lorsque la tension déterminée est la tension U2dc aux bornes de chacun des N2 convertisseurs flottants 30B, la valeur suivante U2dc(n) de ladite tension est calculée à partir de la valeur précédente U2dc(n-1) de ladite tension selon l'équation suivante :

$$U2dc(n) = U2dc(n-1) + \frac{g(Ic)}{U2dc(n-1)} \qquad (4)$$

où g(Ic) représente un terme fonction de l'intensité Ic du courant délivré à la charge.

La fonction g est, par exemple, déterminée à l'aide de l'équation suivante :

$$g(Ic) = - \frac{K2}{C} \ x \ \left(V_L . Ic\right) \ x \ T_e. \qquad (5)$$

En variante, lorsque chacun des convertisseurs est connecté en sortie de l'alimentation en courant continu, la tension déterminée est la tension U1dc aux bornes de chacun des convertisseurs de charge. La valeur suivante U1dc(n) de la tension aux bornes du convertisseur de charge du côté du condensateur de stockage est alors déterminée à partir de la valeur précédente U1dc(n-1) de ladite tension selon l'équation suivante :

$$U1dc(n) = U1dc(n-1) + \frac{h(Ic)}{U1dc(n-1)} \qquad (6)$$

où h(Ic) représente un terme fonction de l'intensité Ic du courant délivré à la charge.

La fonction h est, par exemple, déterminée à l'aide de l'équation suivante :

$$h(Ic) = \frac{1}{C} \ x \ \left( \frac{1}{M} \left(P_{alim} - V_R . Ic\right) - V_L . Ic \right) \ x \ T_e. \qquad (7)$$

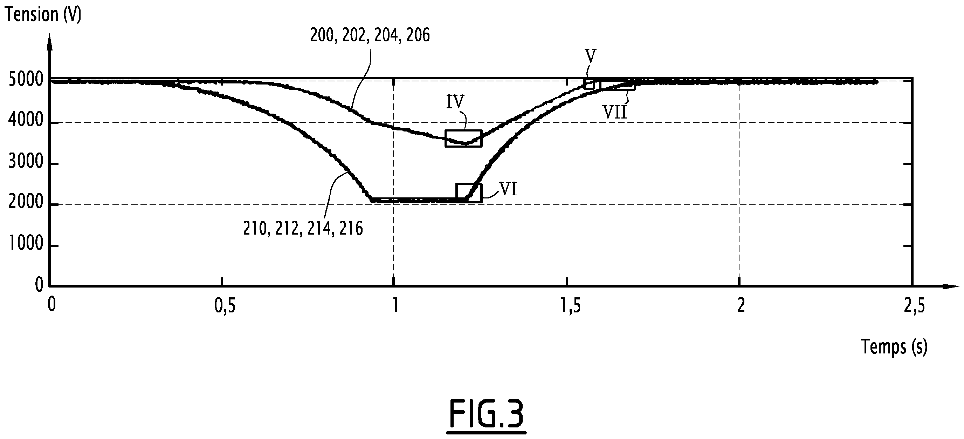

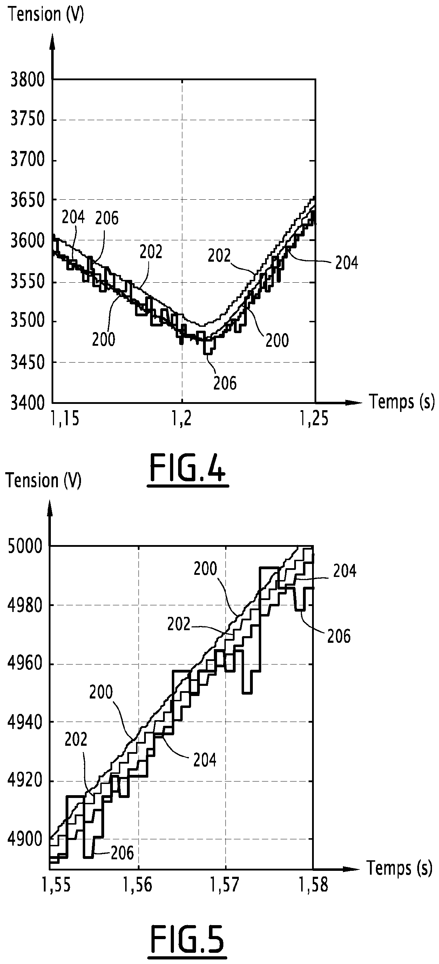

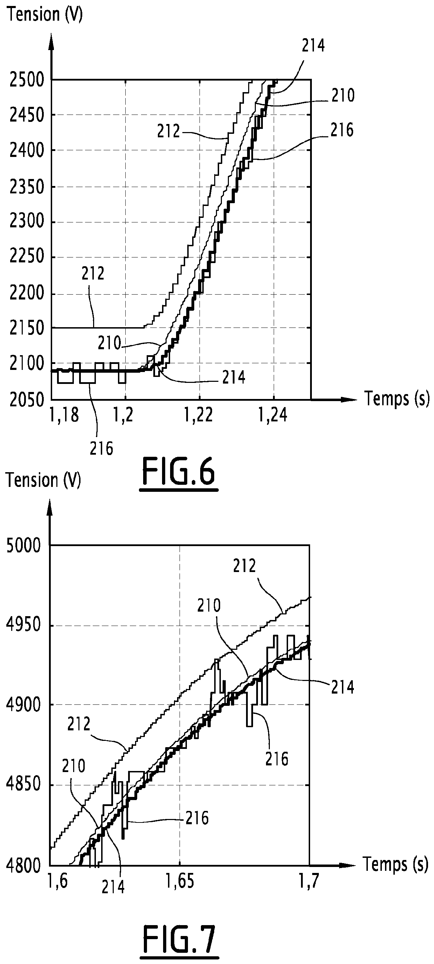

La figure 3 illustre des courbes représentant les différentes tensions mesurées et déterminées, ainsi que des tensions simulées à titre de comparaison, pour les convertisseurs de charge 30A et pour les convertisseurs flottants 30B. Les figures 4 à 7 représentent des agrandissements des zones IV à VII de la figure 3.

Les courbes 200, 202, 204 et 206 sont les courbes de tension aux bornes des convertisseurs de charge 30A du côté du condensateur de stockage associé.

Les courbes 210, 212, 214 et 216 sont les courbes de tension aux bornes des convertisseurs flottants 30B du côté du condensateur de stockage respectif.

Les courbes 200 et 210 représentent des tensions simulées selon les lois électriques, afin de représenter les tensions aux bornes des convertisseurs de charge et aux bornes des convertisseurs flottants sans erreur d'approximation, telle qu'une erreur de mesure, une erreur de calcul ou encore une erreur due à la résolution.

Les courbes 202 et 212 montrent les tensions, respectivement aux bornes des convertisseurs de charge 30A et aux bornes des convertisseurs flottants 30B, déterminées avec la deuxième forte résolution à l'aide des moyens de détermination 44. Dans l'exemple de réalisation des figures 3 à 7, la deuxième forte résolution comporte 32 bits.

Les courbes 204 et 214 représentent des tensions aux bornes des convertisseurs de charge et aux bornes des convertisseurs flottants simulées avec la deuxième forte résolution. Autrement dit, les courbes 204 et 214 sont des courbes simulées correspondant aux courbes 202 et 212. Le décalage entre les courbes 202 et 204, respectivement 212 et 214, est lié au fait que le dispositif de détermination 23 ne prend pas en compte les pertes liées aux convertisseurs 20.

Les courbes 206 et 216 montrent enfin les tensions, respectivement aux bornes des convertisseurs de charge 30A et aux bornes des convertisseurs flottants 30B, mesurées avec la faible résolution à l'aide des moyens de mesure 43. Dans l'exemple de réalisation des figures 3 à 7, la faible résolution comporte 11 bits.

Les courbes 202, 204, 206, 212, 214 et 216 présentent chacune une forme étagée comportant des paliers horizontaux et des portions verticales. Les paliers horizontaux correspondent à la période d'échantillonnage Te et les portions verticales dépendent de la résolution.

Dans l'exemple de réalisation des figures 3 à 7, la période d'échantillonnage Te est identique et égale à 1 ms pour toutes les courbes 202, 204, 206, 212, 214 et 216, de sorte que tous les paliers horizontaux de ces courbes présentent une même longueur. On constate également que les courbes 202 et 204, respectivement 212 et 214, illustrent la deuxième forte résolution avec des portions verticales de faible hauteur, alors que les courbes 206 et 216 illustrent la faible résolution avec des portions verticales de hauteur importante.

On conçoit ainsi que le procédé et le dispositif selon l'invention permettent de déterminer une valeur avec forte résolution de la tension aux bornes du convertisseur du côté du condensateur de stockage, tout en ne nécessitant pas de mesurer la valeur de cette tension avec un instrument de mesure de forte résolution.

En variante, le procédé de détermination comprend la mesure d'une pluralité de valeurs avec la première forte résolution de la tension U1dc, U2c, aux bornes du convertisseur du côté du condensateur de stockage et la mesure d'une valeur avec la faible résolution de l'intensité Ic du courant délivré à la charge. Le procédé de détermination comprend alors la détermination d'une valeur avec la deuxième forte résolution de l'intensité Ic du courant délivré à la charge à partir de la pluralité de valeurs mesurées avec la première forte résolution de la tension U1dc, U2dc aux bornes du convertisseur du côté du condensateur de stockage et de la valeur avec la faible résolution de l'intensité Ic du courant délivré à la charge.

## Revendications

1. Procédé de détermination de la valeur d'une grandeur caractéristique (U1dc, U2dc) d'un système (10) d'alimentation d'une charge (12) comprenant M convertisseur(s) (20) d'un courant continu en un autre courant continu connecté(s) en série aux bornes de la charge (12) d'une part et en sortie d'une alimentation en courant continu (19) d'autre part, M étant supérieur ou égal à 1, et au moins un condensateur de stockage (22) monté en parallèle du ou des convertisseurs (20) du côté opposé à la charge (12),
   **caractérisé en ce qu'**il comprend les étapes suivantes :

   - la mesure d'une pluralité de valeurs avec une première forte résolution d'une première grandeur caractéristique (Ic),
   - la mesure d'une valeur avec une faible résolution d'une deuxième grandeur caractéristique (U1dc, U2dc), et
   - la détermination d'une valeur avec une deuxième forte résolution de la deuxième grandeur caractéristique (U1dc, U2dc) à partir de la pluralité de valeurs mesurées avec la première forte résolution de la première grandeur caractéristique (Ic) et de la valeur avec la faible résolution de la deuxième grandeur caractéristique (U1dc, U2dc), les première et deuxième fortes résolutions étant au moins 10 fois supérieures à la faible résolution.

2. Procédé selon la revendication 1, dans lequel la détermination de la valeur avec la deuxième forte résolution de la deuxième grandeur caractéristique comporte une pluralité d'itérations, une valeur suivante (U1dc(n), U2dc(n)) de la deuxième grandeur caractéristique étant calculée, à chaque itération, à partir d'une valeur précédente (U1dc(n-1), U2dc(n-1)) de la deuxième grandeur caractéristique et d'un terme correctif dépendant de la valeur mesurée, à chaque itération, avec la première forte résolution de la première grandeur caractéristique (Ic), la valeur initiale (U1dc(0), U2dc(0)) de la deuxième grandeur caractéristique étant égale à la valeur avec faible résolution de la deuxième grandeur caractéristique (U1dc, U2dc).

3. Procédé selon la revendication 1 ou 2, dans lequel la première grandeur caractéristique est l'intensité (Ic) du courant délivré à la charge (12), et dans lequel la deuxième grandeur caractéristique est la tension (U1dc, U2dc) aux bornes du convertisseur (20) du côté du condensateur de stockage (12).

4. Procédé selon les revendications 2 et 3, dans lequel chacun des M convertisseur(s) est connecté en sortie de l'alimentation en courant continu, et dans lequel la valeur suivante (U1dc(n)) de la tension aux bornes du convertisseur du côté du condensateur de stockage est déterminée à partir de la valeur précédente (U1dc(n-1)) selon l'équation suivante :

$$U1dc(n) = U1dc(n-1) + \frac{h(Ic)}{U1dc(n-1)},$$

où h(Ic) représente un terme fonction de l'intensité du courant délivré à la charge (12).

5. Procédé selon l'une quelconque des revendications 1 à 3, dans lequel M est strictement supérieur à 1, et dans lequel la pluralité de M convertisseurs est constituée de N1 premier(s) convertisseur(s) (30A) connecté(s) en sortie de l'alimentation en courant continu (19), N1 étant supérieur ou égal à 1, et de N2 second(s) convertisseur(s) (30B) qui ne sont pas connecté(s) en sortie de ladite alimentation (19), N2 étant supérieur ou égal à 1, la somme de N1 et N2 étant égale à M.

**6.** Procédé selon les revendications 2, 3 et 5, dans lequel la deuxième grandeur caractéristique est la tension (U1dc) aux bornes de chaque premier convertisseur (30A) du côté du condensateur de stockage (22) associé, et dans lequel la valeur suivante (U1dc(n)) de ladite tension aux bornes du premier convertisseur (30A) est calculée à partir de la valeur précédente (U1dc(n-1)) de la tension aux bornes du premier convertisseur (30A) selon l'équation suivante :

$$U1dc(n) = U1dc(n-1) + \frac{f(Ic)}{U1dc(n-1)}$$

où f(Ic) représente un terme fonction de l'intensité du courant délivré à la charge (12).

**7.** Procédé selon les revendications 2, 3 et 5, dans lequel la deuxième grandeur caractéristique est la tension (U2dc) aux bornes de chaque second convertisseur (30B) du côté du condensateur de stockage (22), et dans lequel la valeur suivante (U2dc(n)) de ladite tension aux bornes du second convertisseur (30B) est calculée à partir de la valeur précédente (U2dc(n-1)) de ladite tension aux bornes du second convertisseur (30B) selon l'équation suivante :

$$U2dc(n) = U2dc(n-1) + \frac{g(Ic)}{U2dc(n-1)}$$

où g(Ic) représente un terme fonction de l'intensité du courant délivré à la charge (12).

**8.** Procédé selon l'une quelconque des revendications précédentes, dans lequel les première et deuxième fortes résolutions comportent chacune entre 17 et 32 bits.

**9.** Procédé selon l'une quelconque des revendications précédentes, dans lequel la faible résolution comporte entre 5 et 15 bits, de préférence 11 bits.

**10.** Procédé selon l'une quelconque des revendications 2 à 9, dans lequel la période ($T_e$) entre deux itérations est égale à 1 ms.

**11.** Dispositif (23) de détermination d'une grandeur caractéristique (U1dc, U2dc) d'un système (10) d'alimentation d'une charge (12) comprenant M convertisseur(s) (20) d'un courant continu en un autre courant continu connecté(s) en série aux bornes de la charge (12), M étant supérieur ou égal à 1, et au moins un condensateur de stockage monté en parallèle du ou des convertisseurs (20) du côté opposé à la charge (12),
**caractérisé en ce qu'**il comprend :

    - des moyens (42) de mesure d'une pluralité de valeurs avec une première forte résolution d'une première grandeur caractéristique (Ic),
    - des moyens (43) de mesure d'une valeur avec une faible résolution d'une deuxième grandeur caractéristique (U1dc, U2dc), et
    - des moyens (44) de détermination d'une valeur avec une deuxième forte résolution de la deuxième grandeur caractéristique (U1dc, U2dc) à partir de la pluralité de valeurs mesurées avec la première forte résolution de la première grandeur caractéristique (Ic) et de la valeur avec la faible résolution de la deuxième grandeur caractéristique (U1dc, U2dc), les première et deuxième fortes résolutions étant au moins 10 fois supérieures à la faible résolution.

**12.** Système d'alimentation d'une charge, du type comprenant :

    - une alimentation en courant continu (19) reliée à un réseau électrique (16),
    - M convertisseur(s) (20) d'un courant continu en un autre courant continu connecté(s) en série aux bornes de la charge (12), M étant supérieur ou égal à 1,
    - au moins un condensateur de stockage (22) monté en parallèle du ou des convertisseurs (20) du côté opposé à la charge (12), et
    - un dispositif (23) de détermination de la valeur d'une grandeur caractéristique du système d'alimentation (10),

**EP 2 550 539 B1**

**caractérisé en ce que** le dispositif de détermination (23) est conforme à la revendication 11.

13. Système (10) selon la revendication 12, dans lequel l'alimentation en courant continu (19) comprend au moins un transformateur de tension alternative (14) relié au réseau électrique (16) et au moins un redresseur de tension (18) connecté en sortie du transformateur de tension (14).

14. Système (10) selon la revendication 12 ou 13, dans lequel chacun des M convertisseur(s) est connecté en sortie de l'alimentation en courant continu (19).

15. Système (10) selon la revendication 12 ou 13, dans lequel M est strictement supérieur à 1, et dans lequel la pluralité de M convertisseurs est constituée de N1 premier(s) convertisseur(s) (30A) connecté(s) en sortie de l'alimentation en courant continu (19), N1 étant supérieur ou égal à 1, et de N2 second(s) convertisseur(s) (30B) qui ne sont pas connecté(s) en sortie de ladite alimentation (19), N2 étant supérieur ou égal à 1, la somme de N1 et N2 étant égale à M.

**Patentansprüche**

1. Verfahren zur Bestimmung des Wertes einer Kenngröße (U1dc, U2dc) eines Systems (10) zur Versorgung einer Last (12), das M Wandler (20) von Gleichstrom in einen anderen Gleichstrom, der (die) einerseits in Reihe an Anschlüssen der Last (12) und andererseits am Gleichstromversorgungsausgang (19) angeschlossen ist (sind), wobei M größer oder gleich 1 ist, und wenigstens einen Speicherkondensator (22) aufweist, der auf einer der Last (12) gegenüberliegenden Seite zu dem oder den Wandlern (20) parallel geschaltet ist, **dadurch gekennzeichnet, dass** es die folgenden Schritte aufweist:

   - Messen mehrerer Werte mit einer ersten hohen Auflösung einer ersten Kenngröße (Ic),
   - Messen eines Wertes mit einer geringen Auflösung einer zweiten Kenngröße (U1dc, U2dc) und
   - Bestimmen eines Wertes mit einer zweiten hohen Auflösung der zweiten Kenngröße (U1dc, U2dc) aus den mehreren Messwerten mit der ersten hohen Auflösung der ersten Kenngröße (Ic) und dem Wert mit der geringen Auflösung der zweiten Kenngröße (U1dc, U2dc), wobei die erste und die zweite hohe Auflösung wenigstens 10 mal größer als die geringe Auflösung sind.

2. Verfahren gemäß Anspruch 1, wobei das Bestimmen des Wertes mit der zweiten hohen Auflösung der zweiten Kenngröße mehrere Iterationen aufweist, wobei ein nächster Wert (U1dc(n), U2dc(n)) der zweiten Kenngröße bei jeder Iteration aus einem vorherigen Wert (U1dc(n-1), U2dc(n-1)) der zweiten Kenngröße und einem Korrekturkern berechnet wird, der von dem bei jeder Iteration gemessenen Wert mit der ersten hohen Auflösung der ersten Kenngröße (Ic) abhängig ist, wobei der Anfangswert (U1dc(0), U2dc(0)) der zweiten Kenngröße gleich dem Wert mit der geringen Auflösung der zweiten Kenngröße (U1dc, U2dc) ist.

3. Verfahren gemäß Anspruch 1 oder 2, wobei die erste Kenngröße die Stärke (Ic) des der Last (12) zugeführten Stroms ist und wobei die zweite Kenngröße die Spannung (U1dc, U2dc) an den Anschlüssen des Wandlers (20) auf der Seite des Speicherkondensators (12) ist.

4. Verfahren gemäß den Ansprüchen 2 und 3, wobei jeder der M Wandler am Gleichstromversorgungsausgang angeschlossen ist und wobei der nächste Wert (U1dc(n)) der Spannung an den Anschlüssen des Wandlers auf der Seite des Speicherkondensators aus dem vorherigen Wert (U1dc(n-1)) gemäß der folgenden Gleichungen bestimmt wird:

$$U1dc(n) = U1dc(n-1) + \frac{h(Ic)}{U1dc(n-1)},$$

worin h(Ic) einen Funktionsterm der Stärke des der Last (12) zugeführten Stroms darstellt.

5. Verfahren gemäß einem beliebigen der Ansprüche 1 bis 3, wobei M streng größer als 1 ist und wobei die mehreren M Wandler aus N1 erstem (ersten) Wandler(n) (30A), der (die) am Gleichstromversorgungsausgang (19) angeschlossen ist (sind), wobei N1 größer oder gleich 1 ist, und N2 zweitem (zweiten) Wandler(n) (30B) bestehen, der (die) nicht an dem Ausgang der Versorgung (19) angeschlossen ist (sind), wobei N2 größer oder gleich 1 ist, wobei die Summe aus N1 und N2 gleich M ist.

**10**

6. Verfahren gemäß den Ansprüchen 2, 3 und 5, wobei die zweite Kenngröße die Spannung (U1dc) an den Anschlüssen jedes ersten Wandlers (30A) auf der Seite des zugeordneten Speicherkondensators (22) ist und wobei der nächste Wert (U1dc(n)) der Spannung an den Anschlüssen des ersten Wandlers (30A) aus dem vorherigen Wert (U1dc(n-1)) der Spannung an den Anschlüssen des ersten Wandlers (30A) gemäß der folgenden Gleichung berechnet wird:

$$U1dc(n) = U1dc(n\text{-}1) + \frac{f(Ic)}{U1dc(n-1)},$$

worin f(Ic) einen Funktionsterm der Stärke des der Last (12) zugeführten Stroms darstellt.

7. Verfahren gemäß den Ansprüchen 2, 3 und 5, wobei die zweite Kenngröße die Spannung (U2dc) an den Anschlüssen jedes zweiten Wandlers (30B) auf der Seite des Speicherkondensators (22) ist und wobei der nächste Wert (U2dc(n)) der Spannung an den Anschlüssen des zweiten Wandlers (30B) aus dem vorherigen Wert (U2dc(n-1)) der Spannung an den Anschlüssen des zweiten Wandlers (30B) gemäß der folgenden Gleichung berechnet wird:

$$U2dc(n) = U2dc(n\text{-}1) + \frac{g(Ic)}{U2dc(n-1)},$$

worin g(Ic) einen Funktionsterm der Stärke des der Last (12) zugeführten Stroms darstellt.

8. Verfahren gemäß einem beliebigen der vorhergehenden Ansprüche, wobei die erste und die zweite hohe Auflösung jeweils zwischen 17 und 32 Bits aufweisen.

9. Verfahren gemäß einem beliebigen der vorhergehenden Ansprüche, wobei die geringe Auflösung zwischen 5 und 15 Bits, vorzugsweise 11 Bits, aufweist.

10. Verfahren gemäß einem beliebigen der vorhergehenden Ansprüche 2 bis 9, wobei die Periode ($T_e$) zwischen zwei Iterationen 1 ms beträgt.

11. Vorrichtung (23) zur Bestimmung einer Kenngröße (U1dc, U2dc) eines Systems (10) zur Versorgung einer Last (12), das M Wandler (20) von Gleichstrom in einen anderen Gleichstrom, der (die) in Reihe an Anschlüssen der Last (12) angeschlossen ist (sind), wobei M größer oder gleich 1 ist, und wenigstens einen Speicherkondensator aufweist, der auf der der Last (12) gegenüberliegenden Seite parallel zu dem oder den Wandlern (20) geschaltet ist, **dadurch gekennzeichnet, dass** sie aufweist:

- Mittel (42) zur Messung mehrerer Werte mit einer ersten hohen Auflösung einer ersten Kenngröße (Ic),
- Mittel (43) zur Messung eines Wertes mit einer geringen Auflösung einer zweiten Kenngröße (U1dc, U2dc) und
- Mittel (44) zur Bestimmung eines Wertes mit einer zweiten hohen Auflösung der zweiten Kenngröße (U1dc, U2dc) aus den mehreren Messwerten mit der ersten hohen Auflösung der ersten Kenngröße (Ic) und dem Wert mit der geringen Auflösung der zweiten Kenngröße (U1dc, U2dc), wobei die erste und die zweite hohe Auflösung wenigstens 10 mal höher als die geringe Auflösung sind.

12. System zur Versorgung einer Last des Typs aufweisend:

- eine Gleichstromversorgung (19), die an ein elektrisches Netz (16) angeschlossen ist,
- M Wandler (20) von Gleichstrom in einen anderen Gleichstrom, der (die) in Reihe an Anschlüssen der Last (12) angeschlossen ist (sind), wobei M größer oder gleich 1 ist,
- wenigstens einen Speicherkondensator (22), der auf der der Last (12) gegenüberliegenden Seite parallel zu dem oder den Wandlern (20) geschaltet ist, und
- eine Vorrichtung (23) zur Bestimmung des Wertes einer Kenngröße des Versorgungssystems (10),

**dadurch gekennzeichnet, dass** die Bestimmungsvorrichtung (23) gemäß Anspruch 11 ist.

13. System gemäß Anspruch 12, wobei die Gleichstromversorgung (19) wenigstens einen Wechselspannungstransformator (14), der an das elektrische Netz (16) angeschlossen ist, und wenigstens einen Spannungsgleichrichter (18) aufweist, der am Ausgang des Spannungstransformators (14) angeschlossen ist.

14. System gemäß Anspruch 12 oder 13, wobei jeder der M Wandler am Ausgang der Gleichstromversorgung (19) angeschlossen ist.

15. System (10) gemäß Anspruch 12 oder 13, wobei M streng größer als 1 ist und wobei die mehreren M Wandler aus N1 erstem (ersten) Wandler(n) (30A), der (die) am Ausgang der Gleichstromversorgung (19) angeschlossen ist (sind), wobei N1 größer oder gleich 1 ist, und aus N2 zweitem (zweiten) Wandler(n) (30B) bestehen, die nicht am Ausgang der Versorgung (19) angeschlossen ist (sind), wobei N2 größer oder gleich 1 ist, wobei die Summe aus N1 und N2 gleich M ist.

**Claims**

1. Method for determining the value of a characteristic variable (U1dc, U2dc) of a system (10) for supplying a load (12), comprising M converter(s) (20) for converting a direct current into another direct current and connected in series to the terminals of the load (12) on one side and to the output of a direct current supply (19) on the other, wherein M is greater than or equal to 1, and at least one storage capacitor (22) mounted in parallel to the converter(s) (20) on the side opposite the load (12), **characterised in that** it comprises the following steps:

   - measuring, with a first high resolution, a plurality of values of a first characteristic variable (Ic);
   - measuring, with a low resolution, a value of a second characteristic variable (U1dc, U2dc); and
   - determining, with a second high resolution, a value for the second characteristic variable (U1dc, U2dc) based on the plurality of values, measured with the first high resolution, of the first characteristic variable (Ic) and from the value, measured with the low resolution, of the second characteristic variable (U1dc, U2dc), wherein the first and second high resolutions are at least 10 times greater than the low resolution.

2. Method according to claim 1, wherein the determination, with the second high resolution, of the value of the second characteristic variable comprises a plurality of iterations, wherein a following value (U1dc(n), U2dc(n)) of the second characteristic variable is calculated on each iteration from a preceding value (U1dc(n-1), U2dc(n-1)) of the second characteristic variable and from a corrective term dependent on the value, measured on each iteration with the first high resolution, of the first characteristic variable (Ic), wherein the initial value (U1dc(0), U2dc(0)) of the second characteristic variable is equal to the value, measured with low resolution, of the second characteristic variable (U1dc, U2dc).

3. Method according to claim 1 or 2, wherein the first characteristic variable is the intensity (Ic) of the current supplied to the load (12), and wherein the second characteristic variable is the voltage (U1dc, U2dc) at the terminals of the converter (20) on the side of the storage capacitor (12).

4. Method according to claims 2 and 3, wherein each of the M converter(s) is connected at the output of the direct current supply, and wherein the following value (U1dc(n)) of the voltage at the terminals of the converter on the side of the storage capacitor is determined from the preceding value (U1dc(n-1)) according to the following equation:

$$U1dc(n) = U1dc(n-1) + \frac{h(Ic)}{U1dc(n-1)}$$

wherein *h(Ic)* represents a term which is a function of the current intensity supplied to the load (12).

5. Method according to any of claims 1 to 3, wherein M is strictly greater than 1 and wherein the plurality of M converters is formed by N1 first converter(s) (30A) connected at the output of the direct current supply (19), N1 being greater than or equal to 1, and N2 second converter(s) (30B) which are not connected at the output of said supply (19), N2 being greater than or equal to 1, wherein the sum of N1 and N2 is equal to M.

6. Method according to claims 2, 3 and 5, wherein the second characteristic variable is the voltage (U1dc) at the terminals of each first converter (30A) on the side of the associated storage capacitor (22), and wherein the following value (U1dc(n)) of said voltage at the terminals of the first converter (30A) is calculated from the preceding value (U1dc(n-1)) of the voltage at the terminals of the first converter (30A) according to the following equation:

$$U1dc(n) = U1dc(n-1) + \frac{f(Ic)}{U1dc(n-1)}$$

wherein *f(Ic)* represents a term which is a function of the current intensity supplied to the load (12).

7.  Method according to claims 2, 3 and 5, wherein the second characteristic variable is the voltage (U2dc) at the terminals of each second converter (30B) on the side of the storage capacitor (22), and wherein the following value (U2dc(n)) of said voltage at the terminals of the second converter (30B) is calculated from the preceding value (U2dc(n-1)) of said voltage at the terminals of the second converter (30B) according to the following equation:

$$U2dc(n) = U2dc(n-1) + \frac{g(Ic)}{U2dc(n-1)}$$

wherein *g(Ic)* represents a term which is a function of the current intensity supplied to the load (12).

8.  Method according to any of the preceding claims, wherein the first and second high resolutions each comprise between 17 and 32 bits.

9.  Method according to any of the preceding claims, wherein the low resolution comprises between 5 and 15 bits, preferably 11 bits.

10. Method according to any of claims 2 to 9, wherein the period ($T_e$) between two iterations is equal to 1 ms.

11. Device (23) for determining a characteristic variable (U1dc, U2dc) of a system (10) for supplying a load (12), comprising M converter(s) (20) for converting a direct current into another direct current and connected in series to the terminals of the load (12), wherein M is greater than or equal to 1, and at least one storage capacitor (22) mounted in parallel to the converter(s) (20) on the side opposite the load (12), **characterised in that** it comprises:

    - means (42) for measuring, with a first high resolution, a plurality of values of a first characteristic variable (Ic);
    - means (43) for measuring, with a low resolution, a value of a second characteristic variable (U1dc, U2dc); and
    - means (44) for determining, with a second high resolution, a value for the second characteristic variable (U1dc, U2dc) based on the plurality of values, measured with the first high resolution, of the first characteristic variable (Ic) and on the value, measured with the low resolution, of the second characteristic variable (U1dc, U2dc), wherein the first and second high resolutions are at least 10 times greater than the low resolution.

12. System for supplying a load, of the type comprising:

    - a direct current supply (19) connected to an electrical network (16),
    - M converter(s) (20) for converting a direct current into another direct current and connected in series to the terminals of the load (12), M being greater than or equal to 1,
    - at least one storage capacitor (22) mounted in parallel to the converter(s) (20) on the side opposite the load (12), and
    - a device (23) for determining the value of a characteristic variable of the supply system (10),

    **characterised in that** the determination device (23) is in accordance with claim 11.

13. System (10) according to claim 12, wherein the direct current supply (19) comprises at least one alternating voltage transformer (14) connected to the electrical network (16) and at least one voltage rectifier (18) connected at the output to the voltage transformer (14).

14. System (10) according to claim 12 or 13, wherein each of the M converter(s) is connected at the output of the direct current supply (19).

15. System (10) according to claim 12 or 13, wherein M is strictly greater than 1, and wherein the plurality of M converters is formed by N1 first converter(s) (30A) connected at the output of the direct current supply (19), N1 being greater than or equal to 1, and N2 second converter(s) (30B) which are not connected at the output of said supply (19), N2 being greater than or equal to 1, wherein the sum of N1 and N2 is equal to M.

FIG.1

Mesure de U1dc ou U2dc avec la faible résolution:
U1dc(0) := U1dc ;  U2dc(0) := U2dc ⟍ 100

Incrémentation de n
n : =n+1 ⟍ 110

Mesure de Ic avec la première forte résolution ⟍ 120

130

Détermination de U1dc (n) ou de U2dc (n) avec la deuxième forte résolution :

$$U1dc(n) = U1dc(n-1) + \frac{f(Ic)}{U1dc(n-1)}$$

$$U2dc(n) = U2dc(n-1) + \frac{g(Ic)}{U2dc(n-1)}$$

140

Période Te expirée ?

NON          OUI

## FIG.2

FIG.3

FIG.4

FIG.5

Tension (V)

## FIG.6

Tension (V)

## FIG.7

**EP 2 550 539 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1868279 A1

**Littérature non-brevet citée dans la description**

- CERN-PS Main Power Converter Rénovation : How to Provide and Control the Large Flow of Energy for a Rapid Cyclic Machine ?. **BORDRY F et al.** Proceedings of the Particle Accelerator Conférence, 2005. IEEE, 16 Mai 2005, 3612-3614